# DEMANDE DE BREVET EUROPEEN

(11) **EP 2 273 425 A1**
(43) Date de publication de la demande: **12.01.2011**
(21) Numéro de dépôt: 10167392.9
(22) Date de dépôt: 25.06.2010
(51) Int. Cl.: G06K 19/077

(54) **Procédé de raccordement électrique de deux organes entre eux**

(30) Priorité: 29.06.2009 FR 0954412
(71) Demandeur: Oberthur Technologies, 92300 Levallois-Perret (FR)
(72) Inventeur: Laknin, Mourad, 35500, VITRE (FR); Garnier, Laurent, 35680, MOULINS (FR)
(74) Mandataire: Delumeau, François Guy

(57) **Abrégé**

Un des organes (38) est muni d'un fil de connexion électrique (40A, 40B) et l'autre des organes (42) est muni d'une plage de connexion électrique (44). Le procédé comprend une étape d'agencement du fil (40A, 40B) selon au moins un trajet aller-retour de manière à former au moins des première (52) et deuxième (54) portions rectilignes respectivement à l'aller et au retour en passant par au moins une boucle (56) de raccordement des deux portions (52, 54). En outre, le procédé comprend une étape de fixation du fil (40A, 40B) à la plage (44A, 44B) en au moins un point (57, 61) de conduction électrique de manière à ce que chacune des portions rectilignes (52, 54) soient reliées à la plage (44A, 44B).

## Description

La présente invention concerne un procédé de raccordement entre eux d'un premier organe muni d'un fil de connexion électrique et d'un deuxième organe muni d'une plage de connexion électrique.

L'invention concerne également un support pour carte à microcircuit comprenant deux organes raccordés entre eux selon le procédé de raccordement de l'invention et une carte à microcircuit comprenant un tel support.

Elle s'applique plus particulièrement mais non spécifiquement au domaine des cartes à puce utilisant une interface « sans contact ». Une telle carte comprend un organe de communication à champ proche, tel qu'une antenne magnétique permettant d'établir une communication dite «sans contact».

Cette antenne de communication à champ proche est formée par un fil électriquement conducteur enroulé en une pluralité de spires électriquement conductrices. Une telle antenne est munie de deux fils de connexion électrique, chacun étant formés par les extrémités du fil de l'antenne.

Habituellement, le support comprend un corps dans lequel est incorporée l'antenne. Par ailleurs, le support incorpore un deuxième organe tel que des pastilles de contact pour le raccordement de l'antenne avec le microcircuit. Ces pastilles de contact sont munies chacune d'une plage de connexion destinée à être raccordée à un des fils de connexion de l'antenne.

Un tel support est connu de l'état de la technique, notamment du document WO 2008/129526.

Dans ce document, chaque fil de connexion électrique de l'antenne est connecté à une pastille métallique par soudage laser. Ainsi, chaque fil de connexion électrique de l'antenne s'étend au-dessus de la pastille en étant raccordée en au moins un point de soudure à la pastille.

L'inconvénient de cette connexion est que l'antenne et la pastille sont susceptibles d'être désolidarisées lors d'une flexion ou d'une torsion du corps de carte ce qui peut conduire à des faux-contacts et des courts-circuits entre les organes du microcircuit et l'antenne.

Il en résulte qu'un grand nombre de cartes à microcircuit sont défectueuses et doivent être finalement rejetées lors de leur fabrication, ce qui est relativement coûteux.

L'invention a notamment pour but de proposer un procédé de raccordement de deux organes entre eux dont l'un comprend un fil de connexion électrique et l'autre une plage de connexion électrique, en particulier une antenne et une pastille, permettant de réaliser un raccordement fiable et résistant à des déformations intempestives de la carte.

A cet effet, l'invention a pour objet un procédé de raccordement électrique d'un premier organe muni d'un fil de connexion électrique et d'un deuxième organe muni d'une plage de connexion électrique, **caractérisé en ce qu**'il comprend les étapes suivantes :
- d'agencement du fil selon au moins un trajet aller-retour de manière à former au moins des première et deuxième portions sensiblement rectilignes respectivement à l'aller et au retour en passant par au moins une boucle de raccordement des deux portions,
- de fixation du fil à la plage en au moins un point de conduction électrique, de manière à ce que chacune des portions rectilignes soient raccordées électriquement à la plage.

Grâce à ce procédé de raccordement, les caractéristiques de la liaison des deux organes entre eux sont améliorées en termes de fiabilité et de résistance à la flexion.

La présence de la boucle de fil de connexion permet d'obtenir d'une part un double raccordement du fil de fixation à la plage et d'autre part une surface de fixation à la plage relativement large délimitée par les deux portions et la boucle du fil.

Le point de conduction électrique permet non seulement d'assurer la conduction électrique entre les deux organes mais également la fixation mécanique du fil à la plage.

Bien entendu, le fil de connexion peut être agencé selon un trajet plus complexe comprenant plusieurs portions aller-retour en zigzag et autant de points de conduction que de portions, ou éventuellement moins de points de conduction que de portions à condition que chaque portion du fil de connexion soit raccordée électriquement à la plage du second organe.

Dans un mode de réalisation particulier de l'invention, les portions rectilignes sont reliées à la plage en au moins deux points de conduction électrique agencés pour s'étendre chacun respectivement sur les deux portions rectilignes.

Même si au cours d'une torsion, une des portions de la boucle est séparée de la plage de connexion, l'autre portion permet d'assurer le raccordement électrique des deux organes entre eux.

Dans un autre mode de réalisation particulier de l'invention, les portions rectilignes sont reliées à la plage en un point de conduction agencé pour s'étendre sur les deux portions rectilignes.

Dans ce cas, les portions rectilignes sont très proches l'une de l'autre. Il est ainsi possible de considérer que les deux portions rectilignes ne forment qu'une seule portion de diamètre équivalent correspondant au double du diamètre de chaque portion. De ce fait, la liaison entre le fil et la plage au point de conduction est plus rigide. La résistance mécanique du support à la flexion et à la torsion en est améliorée.

Un procédé selon l'invention peut en outre comporter l'une ou plusieurs des caractéristiques selon lesquelles :
- l'étape de fixation du fil à la plage est réalisée par thermo-compression, par exemple à l'aide de moyens à ultra-son ;
- on positionne le fil par rapport à la plage de connexion de manière à ce que les deux portions rectilignes du fil s'étendent en regard de la plage ;
- une des portions rectilignes comprenant l'extrémité du fil, on agence cette portion de manière à ce que l'extrémité s'étende au-delà de la plage.

L'invention a également pour objet un support de carte à microcircuit, comprenant un corps de carte formé dans une masse de matériau incorporant des premier et deuxième organes munis respectivement d'un fil de connexion électrique et d'une plage de connexion électrique, **caractérisé en ce que** les premier et deuxième organes sont raccordés conformément à un procédé selon l'invention.

Un support selon l'invention peut comprendre l'une ou l'autre des caractéristiques selon lesquelles :
- le corps est formé par lamination d'une pile de couches, une des couches incorporant au moins l'un des deux organes ;
- le deuxième organe est choisi parmi une pastille de contact, une borne de connexion d'un composant électronique tel qu'un microcircuit ;
- la boucle s'étendant au-delà de la plage, la boucle est incrustée dans la masse de matériau formant le corps ;
- le deuxième organe comprend une autre plage de connexion et le premier organe est muni d'un autre fil de connexion, les plages et les fils étant raccordés entre eux conformément à un procédé selon l'invention ;
- le deuxième organe comprend au moins une pastille de contact munie d'une première plage de connexion électrique du fil du premier organe et d'une deuxième plage, opposée à la première plage, de connexion électrique d'un microcircuit porté par le support ;
- le premier organe comprend une antenne qui comprend une pluralité de spires enroulées en périphérie du support.

L'invention a enfin pour objet une carte à microcircuit, comprenant un microcircuit et un support de carte portant le microcircuit muni d'une cavité de réception du microcircuit, **caractérisée en ce que**, le support de carte étant selon l'invention, le premier organe comprend une antenne et le deuxième organe comprend une borne de connexion du microcircuit ou une pastille de contact de raccordement de l'antenne au microcircuit.

D'autres caractéristiques et avantages de l'invention apparaîtront à la lumière de la description qui suit, faite en référence aux dessins annexés dans lesquels :
- la figure 1 est une vue en coupe transversale d'une carte à microcircuit comprenant un support de carte selon un premier mode de réalisation de l'invention ;
- la figure 2 est une vue de dessus du support de carte de la figure 1, dans laquelle une antenne et des pastilles métalliques de contact sont représentées en transparence ;
- la figure 3 est une vue en perspective du support de la figure 2 portant l'antenne et les pastilles ;
- la figure 4 est une vue en coupe transversale du support de la figure 1 avant lamination de couches du support entre elles et usinage d'une cavité de réception d'un module à microcircuit ;
- la figure 5 est une vue en perspective du support d'une carte selon un deuxième mode de réalisation de l'invention.

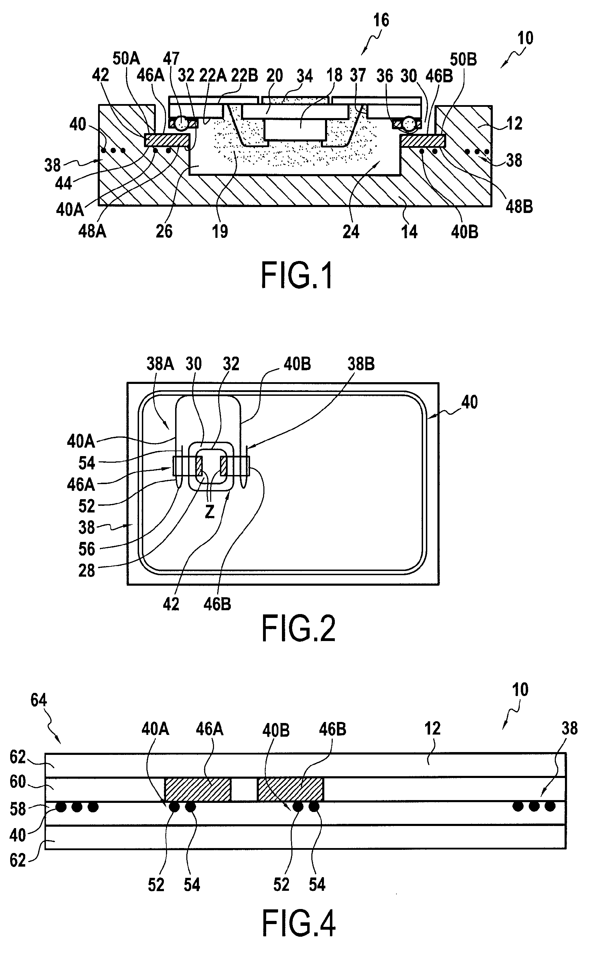

On a représenté sur **la** **figure 1** une carte à microcircuit désignée par la référence générale 10.

La carte 10 comprend un support 12 délimitant le corps 14 de la carte 10 formé dans une masse de matériau, comprenant dans cet exemple essentiellement une matière plastique.

Dans cet exemple, la carte 10 comprend un module 16 à microcircuit. Ce module 16 comprend un microcircuit 18 et un support de module 20 délimitant deux faces opposées dite interne 22A et externe 22B, la face interne 22A portant le microcircuit 18 (désigné également par puce électronique).

En outre, dans cet exemple, comme cela est illustré par **la** **figure 1****,** le support de carte 12 comprend une cavité 24 de logement du module 16 à microcircuit.

Plus précisément, la cavité 24 comprend une zone centrale profonde 26 munie d'un fond 28 pour le logement du microcircuit 18 et une zone périphérique 30 surélevée par rapport à la zone centrale 26 délimitant un gradin 32 avec le fond 28. Cette zone périphérique 30 comprend une surface d'appui surélevée par rapport au fond 28 de la cavité 24 sur laquelle reposent les bords du support de module 20.

Une telle cavité 24 est généralement obtenue par usinage, typiquement par fraisage ou lamage en deux opérations :
- un grand lamage pour former la zone périphérique 30 correspondant à la profondeur du gradin 32,
- un petit lamage pour former la zone centrale 26 plus profonde.

Dans cet exemple, la face externe 22B comprend une plage métallique 34 de contacts externes permettant d'établir une communication dite de contact entre la puce 18 du module 16 et un lecteur de carte externe (non représenté) et la face interne 22A porte une plage métallique 36 de contacts internes du microcircuit 18 à des éléments électroniques incorporés dans le support 12.

Le microcircuit 18 est par exemple encapsulé dans une calotte 19 de résine polymère et est ainsi rapporté par collage dans la zone centrale 26 de la cavité 24. En outre, comme cela est illustré par **la** **figure 1****,** cette puce 18 du module 16 est raccordée de façon filaire aux contacts de la plage externe 34 par l'intermédiaire de vias 37 ménagés dans le support 12. Ainsi, des fils électriquement conducteurs 40 relient le microcircuit 18 et la plage externe 34 en traversant les perçages 37 (ou vias) prévus à cet effet. Par ailleurs, le microcircuit 18 est raccordé par des pistes conductrices (non représentées sur les figures) à la plage interne 36 de contacts.

Dans une variante non illustrée, la puce 18 peut être assemblée selon un autre procédé d'assemblage, tel que par exemple, un procédé de report de puce de type « monté-retourné» (de l'anglais « flip-chip »), c'est-à-dire que tous les contacts de la puce, sous forme de billes ou de bosses métalliques, sont situés sur une seule face. La puce est montée retournée lors du montage de manière à ce que les billes ou les bosses soient soudées aux conducteurs appropriés sur le support 12.

En référence **aux** **figures 1 et 2****,** le corps 14 de la carte à microcircuit 10 incorpore un premier organe 38 muni d'un fil de connexion électrique. De préférence, la carte 10 est de type duale et le premier organe 38 comprend une antenne 38 munie de deux fils de connexion électrique 40A, 40B formés respectivement par les extrémités du fil 40 correspondant respectivement aux extrémités 38A, 38B de l'antenne 38.

L'antenne 38 est par exemple formée par un fil électriquement conducteur 40 enroulé en une pluralité de spires, de préférence en périphérie du support 12, prolongées par les deux parties d'extrémité libre 40A, 40B du fil 40 de l'antenne 38. Ces parties d'extrémité 40A, 40B forment les fils de connexion électrique de l'antenne 38 permettant le raccordement de cette dernière avec d'autres composants portés par le support 12.

Par la suite, on notera par les références numériques les éléments associés à la première extrémité 38A de l'antenne 38 avec un indice A et les éléments associés à la deuxième extrémité 38B avec un indice B.

Dans l'exemple décrit, l'antenne 38 est raccordée au microcircuit 18 porté par le support 20 par l'intermédiaire d'un deuxième organe 42 muni d'au moins une plage de connexion électrique 44. Ce deuxième organe 42 est également incorporé dans le corps 14 de la carte 10.

Plus précisément, les premier 38 et deuxième 42 organes sont raccordés électriquement entre eux.

Le deuxième organe 42 comprend par exemple une pastille métallique 46 de contact, et de préférence, deux pastilles métalliques 46A, 46B de contact destinées chacune au raccordement de chacun des fils de connexion électrique 40A, 40B du premier organe 38.

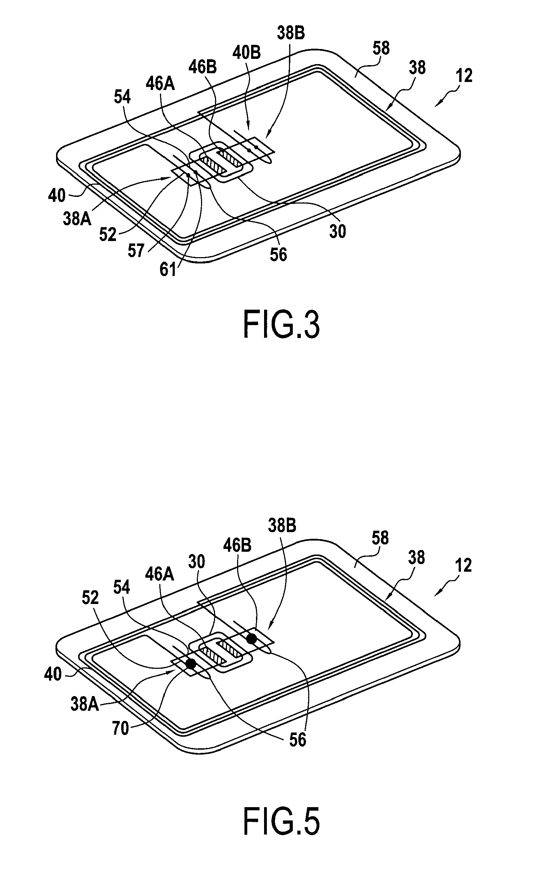

Dans la suite de la description, on décrira en détail le raccordement de l'antenne 38 à la première pastille 46A représentée sur **la** **figure 3****.** Bien entendu, la description détaillée du raccordement de la première pastille 46A s'applique également au raccordement de la deuxième pastille 46B représentée sur les figures.

La pastille 46A est munie d'une première plage 48A de connexion électrique avec le fil 40A et d'une deuxième plage 50A, opposée à la première plage 48A, de connexion électrique de la pastille 46A au microcircuit 18.

Dans l'exemple illustré, les première 48A et deuxième 50A plages sont délimitées respectivement par des première et deuxième faces opposées de la pastille 46A.

Plus particulièrement, le fil de connexion 40A de l'antenne 38, est agencé selon au moins un trajet aller-retour de manière à former au moins des première 52 et deuxième 54 portions rectilignes respectivement à l'aller et au retour en passant par au moins une boucle 56 de raccordement entre elles des deux portions 52 et 54.

Plus particulièrement, le fil de connexion électrique 40A est fixé à la plage métallique 48A correspondante du deuxième organe 42, en au moins un point de conduction électrique de manière à ce que chacune des portions rectilignes 52, 54 soient reliées à la plage 44A, 44B. Par exemple, le point de conduction électrique est réalisé par soudage, thermocompression ou tout autre procédé adapté.

Dans un premier mode de réalisation de l'invention illustré par **la** **figure 3****,** chacune des portions rectilignes sont reliées à la plage 44A, 44B en au moins deux points de conduction électrique 57, 61 agencés pour s'étendre chacun respectivement sur les deux portions rectilignes 52, 54.

Dans une variante non illustrée, l'antenne 38 peut directement être raccordée au microcircuit 18 sans nécessiter le raccordement intermédiaire avec des pastilles de contact. Dans ce cas, le microcircuit est muni d'une borne comprenant une plage de connexion électrique du fil de connexion de l'antenne.

Comme cela est illustré en détail sur **la** **figure 3****,** l'extrémité 40A du fil 40 est positionné par rapport à la plage 48A de manière à ce que les deux portions rectilignes 52, 54 du fil 40 s'étendent en regard de la plage 48A.

Dans l'exemple illustré, la deuxième portion rectiligne 54 comprend l'extrémité du fil 40A de l'antenne. Cette portion 54 est de préférence agencée de manière à ce que l'extrémité 40A s'étende au-delà de la surface de la plage 48A. Ceci permet d'assurer un meilleur ancrage de l'extrémité 38A de l'antenne 38 dans le support 14.

De préférence, la boucle 56 s'étend également au-delà de la plage de connexion 48A et est incrustée dans la masse de matériau formant le corps 14. Ceci permet notamment de réaliser un ancrage de l'antenne 38 dans le support 12.

De préférence, la fixation du fil 40A à la plage 44A correspondante est réalisée par thermo-compression, par exemple à l'aide de moyens à ultra-son. En variante, la fixation peut être réalisée par soudage laser, par collage, etc.

En outre, le support 12 est formé de préférence par lamination d'une pluralité de couches superposées pour former une pile dans lesquelles sont insérés les différents éléments électroniques de la carte 10 tels que l'antenne 38 et les pastilles de contact 46. Ainsi, une des couches de la pile 64 incorpore au moins l'un des deux organes. Le module 16 est encarté une fois la lamination des couches réalisée.

Dans l'exemple décrit, le microcircuit 18 n'est pas en contact direct avec les pastilles 46A, 46B mais est raccordé électriquement aux pastilles 46A, 46B par l'intermédiaire des contacts de la plage métallique interne 36, cette plage métallique interne 36 étant raccordée elle-même aux pastilles électriques 46A, 46B par une colle électriquement isolante dans laquelle sont incorporées des particules électriquement conductrices 47 (**figure 1**).

En référence à **la** **figure 4****,** le support 12 comprend au moins une première couche interne 58 portant l'antenne 38 et une deuxième couche interne 60 portant les pastilles 46. Ces couches sont réalisées dans un matériau isolant tel qu'une matière plastique.

En outre, ces première 58 et deuxième 60 couches sont intercalées entre deux couches externes 62, dites de compensation, ayant pour fonction de compenser les éventuels défauts de surface des couches internes 58 et 62.

De préférence, comme cela est illustré sur les figures, les deux pastilles 46A, 46B s'étendent sensiblement dans un même plan du support 12, défini par la couche interne 58.

L'antenne 38 est incorporée dans la couche centrale 58 selon une technique classique (sérigraphie, gravure, insertion filaire, ultra-son, etc.).

Par souci de simplification, on a représenté sur **la** **figure 4** seulement les quatre couches centrales 58, 60 et 62 de la pile 64 résultant de cette superposition. Bien entendu, d'autres couches non représentées peuvent être rajoutées dans la pile.

On a représenté sur **la** **figure 5****,** un deuxième mode de réalisation de l'invention. Sur cette figure, les éléments analogues à ceux des figures précédentes sont désignés par des références identiques.

Dans ce deuxième mode de réalisation, les portions rectilignes 52, 54 sont reliées à la plage 44A, 44B en un point de conduction 70 agencé pour s'étendre sur les deux portions rectilignes 52, 54.

Grâce à cet agencement particulier, la liaison entre la pastille et l'antenne 38 est plus rigide. En effet, du fait que le point 70 s'étend sur les deux portions 52, 54 de la boucle 56, la liaison est renforcée car le diamètre équivalent des deux portions 52, 54 est plus grand que le diamètre d'une portion 52 ou 54 prise seule. Ainsi, les performances mécaniques de flexion, torsion sont améliorées et le produit résultant en est plus fiable.

Dans les premier et deuxième modes de réalisation illustrés par **les** **figures 3 et 5**, on notera que les portions de fil 52 ou 54 sont disposées sur chacune des pastilles sensiblement en retrait de l'emplacement prévu pour la cavité 24 apte à recevoir le module à microcircuit. Il est ainsi possible d'éviter que le fil 40 de l'antenne 38 ne soit endommagé lors de l'opération d'usinage de la cavité 24.

On va maintenant décrire les principales étapes d'un procédé de fabrication d'une carte à microcircuit comprenant deux organes raccordés entre eux par un procédé de raccordement selon l'invention.

Au cours d'une première étape, l'antenne 38 est incorporée dans un substrat formant la première couche interne 58 par des moyens à ultra-son par exemple. Le fil 40 de l'antenne 38 est ainsi enroulé de manière à former les spires autour de la périphérie du support. Les fils de connexion électrique 40A, 40B sont également agencés selon le trajet prédéfini, tel que décrit ci-dessus.

Puis, deux trous ayant une forme complémentaire à celle des pastilles sont réalisés dans le substrat formant la deuxième couche interne 58. Les pastilles de contact 46A, 46B sont ensuite positionnées dans les trous correspondants.

Les couches internes 58, 60 sont alors superposées de manière à ce que les portions rectilignes des fils 40A, 40B coïncident sensiblement en coïncidence avec les plages 48A, 48B des pastilles 46A, 46B.

Les fils de connexion électrique sont alors fixés aux pastilles 46A, 46B correspondantes par formation de deux points de conduction sur chacune des portions des fils de connexion électrique de manière à établir les deux connexions électriques.

De préférence, et comme cela est illustré sur **la** **figure 3****,** pour effectuer l'opération de fixation des deux organes 38 et 42 entre eux, la couche 58 incorporant les pastilles est placée en dessous de la couche incorporant l'antenne 38. Puis, la pile formée par ces deux couches est ensuite retournée une fois la fixation effectuée.

Les couches internes 58 et 60 sont ensuite intercalées entre les deux couches externes 62 en matière plastique et éventuellement d'autres couches externes sont ajoutées pour former une pile qui est ensuite soumise à un cycle de lamination.

A l'issue du cycle de lamination, on obtient un corps de carte dans lequel sont noyées les deux pastilles 46A, 46B et l'antenne 38. De préférence, le corps de carte 14 a une épaisseur sensiblement de l'ordre de 760 microns, suivant la norme ISO 7816 des cartes à microcircuit.

Le module 16 est ensuite encarté dans le corps 14 de la carte 10. Ainsi, on forme alors la cavité 24 dans le corps 14 du support de carte 12 à l'emplacement prédéfini. Cette cavité 24 est formée en deux opérations, une première opération pour réaliser un grand lamage correspondant à la zone périphérique 30 et une deuxième opération pour réaliser un petit lamage correspondant à la zone centrale 26 plus profonde.

A cet effet, un outil de fraisage adapté usine la cavité 24, par exemple par rotation d'une fraise. L'outil 56 forme d'abord le grand lamage ce qui permet de mettre à nu une partie de chacune des pastilles 46 puis forme le petit lamage de manière à partiellement découper chacune des extrémités des pastilles 46. On a représenté sur **la** **figure 2****,** les zones Z découpées de la pastille avec des hachures.

La mise à nue d'une partie de chacune des pastilles 46 permet ainsi de former deux plages de connexion électrique avec le microcircuit 18.

Le support 12 ainsi obtenu à l'issue de ces différentes étapes comprend l'antenne 38 et les pastilles 46 telles qu'agencées entre elles sur **la** **figure 2****.**

Le module 16 est ensuite rapporté dans la cavité 24 de manière à ce que les bords de la face interne 22A du support de module 20 reposent sur la surface d'appui 32 et de manière à ce que les contacts internes 36 de la plage interne du module 16 coïncident avec la partie mise à nue de chacune des pastilles 46 (**figure 1**)

Grâce à l'invention, les pastilles de contact sont fixées de façon fiable à l'antenne 38 tout en assurant une résistance de ce raccordement en torsion et en flexion.

Il est bien entendu que les modes de réalisation qui viennent d'être décrits ne présentent aucun caractère limitatif et qu'ils pourront recevoir toute modification désirable sans sortir pour cela du cadre de l'invention.

En particulier, il serait conforme à l'invention d'appliquer le procédé de raccordement à deux organes d'un support à circuit imprimé ou autres sans exclusivement l'appliquer à un support de carte à microcircuit.

## Revendications

1. Procédé de raccordement électrique d'un premier organe (38) muni d'un fil de connexion électrique (40A, 40B) et d'un deuxième organe (42) muni d'une plage de connexion électrique (44A, 44B), **caractérisé en ce qu'**il comprend les étapes suivantes :
- d'agencement du fil (40A, 40B) selon au moins un trajet aller-retour de manière à former au moins des première (52) et deuxième (54) portions sensiblement rectilignes respectivement à l'aller et au retour en passant par au moins une boucle (56) de raccordement des deux portions (52, 54),
- de fixation du fil (40A, 40B) à la plage (44A, 44B) en au moins un point (57, 61 ; 70) de conduction électrique de manière à ce que chacune des portions rectilignes (52, 54) soient reliées à la plage (44A, 44B).

2. Procédé selon la revendication précédente, dans lequel chacune des portions rectilignes sont reliées à la plage (44A, 44B) en au moins deux points de conduction électrique (57, 61) agencés pour s'étendre chacun respectivement sur les deux portions rectilignes (52, 54).

3. Procédé selon la revendication 1, dans lequel les portions rectilignes (52, 54) sont reliées à la plage (44A, 44B) en un point de conduction (70) agencé pour s'étendre sur les deux portions rectilignes (52, 54).

4. Procédé selon l'une quelconque des revendications précédentes, dans lequel l'étape de fixation du fil (40A, 40B) à la plage (44A, 44B) est réalisée par thermo-compression, par exemple à l'aide de moyens à ultra-son.

5. Procédé selon l'une quelconque des revendications précédentes, dans lequel on positionne le fil (40A, 40B) par rapport à la plage (44A, 44B) de connexion de manière à ce que les deux portions rectilignes (52, 54) du fil (40) s'étendent en regard de la plage (44A, 44B).

6. Procédé selon l'une quelconque des revendications précédentes, dans lequel, une des portions rectilignes (54) comprenant l'extrémité du fil (40A, 40B), on agence cette portion (54) de manière à ce que l'extrémité s'étende au-delà de la plage (44A, 44B).

7. Support (12) de carte à microcircuit, comprenant un corps (14) de carte formé dans une masse de matériau incorporant des premier (38) et deuxième (42) organes munis respectivement d'un fil de connexion électrique (40A, 40B) et d'une plage de connexion électrique (44A, 44B), **caractérisé en ce que** les premier (38) et deuxième (42) organes sont raccordés conformément à un procédé selon l'une quelconque des revendications précédentes.

8. Support (12) selon la revendication précédente, dans lequel le corps (14) est formé par lamination d'une pile (64) de couches, une des couches (58, 60) incorporant au moins l'un des deux organes (38, 42).

9. Support (12) selon la revendication 7 ou 8, dans lequel le deuxième organe (42) est choisi parmi une pastille de contact (46A, 46B), une borne de connexion d'un composant électronique tel qu'un microcircuit.

10. Support (12) selon l'une quelconque des revendications 7 à 9, dans lequel, la boucle (56) s'étendant au-delà de la plage (44A, 44B), la boucle (56) est incrustée dans la masse de matériau formant le corps.

11. Support (12) selon l'une quelconque des revendications 7 à 10, dans lequel le deuxième organe (42) comprend une autre plage de connexion (44B) et le premier organe (38) est muni d'un autre fil de connexion (40B), les plages (44A, 44B) et les fils (40A, 40B) étant raccordés entre eux conformément à un procédé selon l'une quelconque des revendications 1 à 6.

12. Support (12) selon l'une quelconque des revendications 7 à 11, dans lequel le deuxième organe (42) comprend au moins une pastille de contact (46A, 46B) munie d'une première plage (44A, 44B) de connexion électrique du fil (40A, 40B) du premier organe (38) et d'une deuxième plage (44A, 44B), opposée à la première plage (44A, 44B), de connexion électrique d'un microcircuit (18) porté par le support (12).

13. Support (12) selon l'une quelconque des revendications 7 à 12, dans lequel le premier organe (38) comprend une antenne (38) qui comprend une pluralité de spires enroulées en périphérie du support (12).

14. Carte (10) à microcircuit, comprenant un microcircuit (18) et un support (12) de carte portant le microcircuit (18) muni d'une cavité (24) de réception du microcircuit (18), **caractérisée en ce que**, le support de carte (12) étant selon l'une quelconque des revendications 7 à 13, le premier organe (38) comprend une antenne et le deuxième organe (42) comprend une borne de connexion du microcircuit (18) ou une pastille de contact (46A, 46B) de raccordement de l'antenne (38) au microcircuit (18).
